# EUROPEAN PATENT APPLICATION

(11) **EP 4 351 048 A1**
(43) Date of publication of application: **10.04.2024**
(21) Application number: 21945612.6
(22) Date of filing: 09.07.2021
(51) Int. Cl.: H04L 1/00

(54) **COMMUNICATION METHOD AND COMMUNICATION APPARATUS**

(30) Priority: 18.06.2021 WO PCT/CN2021/101080
(71) Applicant: Huawei Technologies Co., Ltd., Longgang Shenzhen, Guangdong 518129 (CN)
(72) Inventor: JIN, Lili, Shenzhen, Guangdong 518129 (CN); WANG, Jian, Shenzhen, Guangdong 518129 (CN); CHENG, Xingqing, Shenzhen, Guangdong 518129 (CN)
(74) Representative: Huawei European IPR
(86) International application number: PCT/CN2021/105561
(87) International publication number: WO 2022/262030

(57) **Abstract**

This application provides a communication method and a communication apparatus, which may be applied to the field of short-range communication, for example, a cockpit domain. A sending device performs first encoding on at least one first code block, to obtain at least one first code word, where each first code block includes a first information block and a first check block used to check the first information block. The sending device performs at least one type of second encoding on at least one second code block, to obtain at least one second code word, where the at least one second code block includes a second check block, the second check block is used to check a portion of information in the at least one second code block, and a code length of the first code word is greater than a code length of the second code word. The sending device generates and sends a data packet that includes the at least one first code word and the at least one second code word. A receiving device decodes the data packet to obtain the at least one first code block and the at least one second code block. The solutions provided in embodiments of this application help improve communication quality and communication efficiency during receiving and sending.

## Description

### TECHNICAL FIELD

This application relates to the communication field, more specifically, to a communication method and a communication apparatus, and in particular, to a short-range communication method and apparatus.

### BACKGROUND

A transmit end communication apparatus may send data to a receive end communication apparatus, and the receive end communication apparatus may report a data receiving status to the transmit end communication apparatus. For example, the transmit end communication apparatus may send data and a check code to the receive end communication apparatus, and the receive end communication apparatus may check the check code, to determine whether the receive end apparatus successfully receives the data. If the receive end communication apparatus can successfully receive the data, the receive end communication apparatus may send an acknowledgment (acknowledge, ACK) signal to the transmit end communication apparatus. If the receive end communication apparatus cannot successfully receive the data, the receive end communication apparatus may send a negative acknowledgment (negative acknowledgment, NACK) signal to the transmit end communication apparatus. The transmit end communication apparatus may determine, based on the data receiving status, whether to resend the data to the receive end communication apparatus. This process may be referred to as an automatic retransmission process. Communication quality and communication efficiency in the automatic retransmission process are always concerned.

### SUMMARY

This application provides a communication method and a communication apparatus. The communication method helps balance and even improve communication quality and communication efficiency between a transmit end communication apparatus and a receive end communication apparatus.

According to a first aspect, a communication method is provided. The method includes:
generating a data packet, where the data packet includes at least one first code word and at least one second code word, and a code length of the first code word is greater than a code length of the second code word; and
sending the data packet.

The at least one first code word is obtained by performing first encoding on at least one first code block, each of the at least one first code block includes a first information block and a first check block used to check the first information block, the at least one second code word is obtained by performing at least one type of second encoding on at least one second code block, the at least one second code block includes a second check block, and the second check block is used to check a portion of information in the at least one second code block.

A code block may be bit data before encoding. A code word may be encoded bit data. A code length may be a length of the code word. Information content in the code block may include an information block and a check block. The check block may be bit data having a check function. The information block may not have a check function.

For information of any quantity of bits, a data packet including a plurality of code words may be obtained through segmentation and encoding. The data packet may include two code words with different code lengths. The code words with different code lengths may be obtained through encoding separately, and a code length of each code word meets a preset code length. Therefore, rate matching can be omitted, and power consumption of data transmission can be reduced. In addition, each first code word with a larger code length may be checked by using the first check block, and a plurality of second code blocks with a smaller code length are checked together. This helps reduce an overhead proportion of the check blocks in the data packet, reduce signaling overheads, and improve communication efficiency.

With reference to the first aspect, in some implementations of the first aspect, the method further includes:
obtaining at least one first information block; and
generating at least one first check block in the at least one first code block, where the first check block corresponds to a first information block in a first code block in which the first check block is located.

A first portion of to-be-sent information may have a large quantity of bits, and may be suitable for being divided into the first code word. The first check block may be obtained by performing check encoding on the first portion.

With reference to the first aspect, in some implementations of the first aspect, the second check block is generated based on at least a portion of information other than the second check block in the at least one second code block.

A second portion of the to-be-sent information does not have a suitable quantity of bits for being divided into the first code word. Therefore, the second portion may be divided into a plurality of second code words, a code length of each second code word may be small, and the second check block may be obtained by performing check encoding on the second portion.

With reference to the first aspect, in some implementations of the first aspect, the at least one second code block includes redundant information, and in the at least one second code block, the redundant information is located before or after the second check block.

When a quantity of bits related to the to-be-sent information and a quantity of bits of the second check block are insufficient to fill a plurality of second code blocks, the plurality of second code blocks may include redundant information, so that each second code block can meet a preset code block code length, and a code length of each second code word meets the preset code length. If the redundant information is located before the second check block, the second check block may be used to check all information in the plurality of second code blocks except the second check block. The second check block may be located at a tail of the plurality of second code blocks, and the redundant information is checked by using the second check block. If the redundant information is located after the second check block, the second check block may be used to check a portion of information other than the second check block in the plurality of second code blocks. The redundant information is not checked by using the second check block, and a block error rate is low. Alternatively, the redundant information is located at a front location in a 1^{st} second code block in the at least one second code block. Based on this design, when polar code (Polar code, or the like) encoding is used in an encoding scheme, because transmission reliability of a bit at a rear location in a code block may be higher than transmission reliability of a bit at a front location in the code block, padding the redundant information at the front location in the second code block helps place valid information at a rear location with higher reliability in the second code block, thereby effectively improving reliability of transmitting the valid information.

With reference to the first aspect, in some implementations of the first aspect, in the at least one second code block, the second check block is located in one or more consecutive code blocks.

A minimum quantity of bits of the second code block may not be limited by the quantity of bits of the second check block. This helps improve segmentation flexibility of the plurality of second code blocks.

With reference to the first aspect, in some implementations of the first aspect, the data packet includes L data groups, the L data groups include L₁ first data groups and one second data group, each of the L₁ first data groups includes n first code words, the second data group includes the at least one second code word, and L₁ and n are greater than or equal to 1.

A larger quantity of code words included in a data group may indicate a higher block error rate of the data group. A smaller quantity of code words included in a data group may indicate a lower block error rate of the data group. Quantities of first code words in a plurality of first data groups may be the same. This helps balance block error rates of the plurality of first data groups. With reference to the first aspect, in some implementations of the first aspect, the method further includes:
receiving L pieces of feedback information corresponding to the data packet, where the L pieces of feedback information correspond to the L data groups.

A plurality of code words may be divided into a plurality of data groups. A receiving device may feed back a data receiving and sending status for the L data groups. Compared with an implementation in which a data receiving and sending status is fed back for each check block, this helps reduce signaling overheads of feedback information.

With reference to the first aspect, in some implementations of the first aspect, n meets n=ceil(H/(L-1)), and H is a total quantity of the at least one first code word.

With reference to the first aspect, in some implementations of the first aspect, when mod(H, (L-1))>0, the L data groups further include L₂ third data groups, and each of the L₂ third data groups includes p first code words, where L₂ is a positive integer less than L-L₁, and p meets p=floor(H/(L-1)).

When a plurality of first code words cannot be evenly distributed to a plurality of data groups, a quantity of code words in the first data group and a quantity of code words in the third data group are adjusted, so that a difference between the quantity of code words in the first data group and the quantity of code words in the third data group is small. This helps balance block error rates of the plurality of data groups, and improves data transmission reliability.

With reference to the first aspect, in some implementations of the first aspect, L₁ meets L₁=mod(H, (L-1)), and L₂ meets L₂=L-mod(H, (L-1))-1.

The plurality of first data groups include three data group types: a first data group, a second data group, and a third data group. This helps simplify data group division.

With reference to the first aspect, in some implementations of the first aspect, the at least one first code word has a same code length.

The code length of the first code word may correspond to a maximum code length of the data packet. Encoding and decoding of the first code word may be related to the maximum code length. This helps simplify receiving and sending of the first code word.

With reference to the first aspect, in some implementations of the first aspect, the at least one second code word includes at least two second code words whose code rates are different.

The plurality of second code words have different code lengths, and the plurality of second code words may also have different code rates. For example, a smaller code length of a code word indicates a smaller code rate, so that the plurality of second code words may have similar receiving and sending performance.

With reference to the first aspect, in some implementations of the first aspect, a code length sum of the at least one second code word is less than the code length of the first code word.

Most of the to-be-sent information is encoded as the first code word with a longer code length, and a small portion of the to-be-sent information is encoded as the plurality of second code words with a shorter code length. This helps simplify data packet receiving and sending.

According to a second aspect, a communication method is provided. The method includes:
receiving a data packet, where the data packet includes at least one first code word and at least one second code word, and a code length of the first code word is greater than a code length of the second code word; and
performing first decoding on the at least one first code word, and performing at least one type of second decoding on the at least one second code word, to obtain at least one first code block and at least one second code block, where each of the at least one first code block includes a first information block and a first check block used to check the first information block, the at least one second code block includes a second check block, and the second check block is used to check a portion of information in the at least one second code block.

For a data packet that includes a plurality of code words, information of any quantity of bits may be obtained through decoding. The data packet may include two code words with different code lengths, and a code length of each code word meets a preset code length. Code words with different code lengths may be separately decoded. Therefore, rate matching can be omitted, and power consumption of data transmission can be reduced. In addition, each first code word with a larger code length may be checked by using the first check block, and a plurality of second code blocks with a smaller code length are checked together. This helps reduce an overhead proportion of the check block in the code block, reduce signaling overheads, and improve communication efficiency.

With reference to the second aspect, in some implementations of the second aspect, the first information block in the first code block is obtained through check decoding based on the first check block in the first code block.

The received first code word may be decoded, to obtain the first portion of the information with a larger quantity of bits. The first portion of the information may be checked and decoded, to obtain the first check block.

With reference to the second aspect, in some implementations of the second aspect, at least a portion of information other than the second check block in the at least one second code block is obtained through check decoding based on the second check block.

The received plurality of second code words may be decoded, to obtain the second portion of the information with a smaller quantity of bits. The second portion of the information may not be suitable for belonging to the first code word. Information other than the second check block in the second portion of the information may be obtained through check decoding based on the second check block.

With reference to the second aspect, in some implementations of the second aspect, the at least one second code block includes redundant information, and in the at least one second code block, the redundant information is located before or after the second check block, or is located at a front location in a 1^{st} second code block in the at least one second code block.

When a quantity of bits of valid information and a quantity of bits of the second check block are insufficient to fill a plurality of second code blocks, the plurality of second code blocks may include redundant information, so that each second code block can meet a preset code block code length, and a code length of each second code word meets the preset code length. If the redundant information is located before the second check block, the second check block may be used to check all information in the plurality of second code blocks except the second check block. The second check block may be located at a tail of the plurality of second code blocks, and the redundant information is checked by using the second check block. If the redundant information is located after the second check block, the second check block may be used to check a portion of information other than the second check block in the plurality of second code blocks. The redundant information is not checked by using the second check block, and a block error rate is low. Alternatively, the redundant information is located at a front location in a 1^{st} second code block in the plurality of second code block. When polar code (Polar code or the like) encoding is used in an encoding scheme, because transmission reliability of a bit at a rear location in a code block may be higher than transmission reliability of a bit at a front location in the code block, padding the redundant information at the front location in the second code block helps place valid information at a rear location with higher transmission reliability in the second code block, thereby effectively improving reliability of transmitting the valid information.

With reference to the second aspect, in some implementations of the second aspect, in the at least one second code block, the second check block is located in one or more consecutive code blocks.

A minimum quantity of bits of the second code block may not be limited by the quantity of bits of the second check block, and the second check block may be separately encoded into one or more second code words. This helps improve segmentation flexibility of the plurality of second code blocks that are encoded by using the second check block.

With reference to the second aspect, in some implementations of the second aspect, the data packet includes L data groups, the L data groups include L₁ first data groups and one second data group, each of the L₁ first data groups includes n first code words, the second data group includes the at least one second code word, and L₁ and n are greater than or equal to 1.

A larger quantity of code words included in a data group may indicate a higher block error rate of the data group. A smaller quantity of code words included in a data group may indicate a lower block error rate of the data group. Quantities of first code words in the plurality of first data groups may be the same. This helps balance block error rates of the plurality of first data groups.

With reference to the second aspect, in some implementations of the second aspect, the method further includes:
sending L pieces of feedback information corresponding to the data packet, where the L pieces of feedback information correspond to the L data groups.

A plurality of code words may be divided into a plurality of data groups. A receiving device may feed back a data receiving and sending status for the L data groups. Compared with an implementation in which a data receiving and sending status is fed back for each check block, this helps reduce signaling overheads of feedback information.

With reference to the second aspect, in some implementations of the second aspect, n meets n=ceil(H/(L-1)), and H is a total quantity of the at least one first code word.

With reference to the second aspect, in some implementations of the second aspect, when mod(H, (L-1))>0, the L data groups further include L₂ third data groups, and each of the L₂ third data groups includes p first code words, where L₂ is a positive integer less than L-L₁, and p meets p=floor(H/(L-1)).

When a plurality of first code words cannot be evenly distributed to a plurality of data groups, a quantity of code words in the first data group and a quantity of code words in the third data group are adjusted, so that a difference between the quantity of code words in the first data group and the quantity of code words in the third data group is small. This helps balance block error rates of the plurality of data groups, and improves data transmission reliability.

With reference to the second aspect, in some implementations of the second aspect, L₁ meets L₁=mod(H, (L-1)), and L₂ meets L₂=L-mod(H, (L-1))-1.

The plurality of first data groups include three data group types: a first data group, a second data group, and a third data group. This helps simplify data group division.

With reference to the second aspect, in some implementations of the second aspect, the at least one first code word has a same code length.

The code length of the first code word may correspond to a maximum code length of the data packet. Encoding and decoding of the first code word may be related to the maximum code length. This helps simplify receiving and sending of the first code word.

With reference to the second aspect, in some implementations of the second aspect, the at least one second code word includes at least two second code words whose code rates are different.

The plurality of second code words have different code lengths, and the plurality of second code words may have different code rates. For example, a smaller code length of a code word indicates a smaller code rate, so that the plurality of second code words may have similar receiving and sending performance.

With reference to the second aspect, in some implementations of the second aspect, a code length sum of the at least one second code word is less than the code length of the first code word.

The first code word with a longer code length may be decoded to obtain most valid information, and the plurality of second code words with a shorter code length may be decoded to obtain a small portion of encoded valid information. This helps simplify receiving and sending of the data packet.

According to a third aspect, a communication method is provided. The method includes:
generating a data packet, where the data packet includes a plurality of second code words; and
sending the data packet.

The plurality of second code words are obtained by performing at least one type of second encoding on a plurality of second code blocks, the plurality of second code blocks include a second check block, and the second check block is used to check at least a portion of information in the plurality of second code blocks.

Optionally, a code length of each second code word is less than a preset maximum code length.

Information of any quantity of bits may be encoded as a data packet including a plurality of code words. The plurality of code words may be obtained through encoding, and a code length of each code word meets a preset code length. Therefore, time consumption of data transmission is reduced. For example, rate matching time may be reduced. In addition, a plurality of code blocks with a smaller code length are checked together. This helps reduce a code length of the check block in the data packet, reduce signaling overheads, and improve communication efficiency.

With reference to the third aspect, in some implementations of the third aspect, the second check block is generated based on at least a portion of information other than the second check block in the at least one second code block.

With reference to the third aspect, in some implementations of the third aspect, the plurality of second code blocks include redundant information, and in the plurality of second code blocks, the redundant information is located before or after the second check block, or is located at a front location in a 1^{st} second code block in the plurality of second code blocks.

With reference to the third aspect, in some implementations of the third aspect, in the plurality of second code blocks, the second check block is located in one or more consecutive code blocks.

With reference to the third aspect, in some implementations of the third aspect, the data packet includes a second data group, and the second data group includes the plurality of second code words.

With reference to the third aspect, in some implementations of the third aspect, the method further includes:
receiving feedback information corresponding to the second data group.

With reference to the third aspect, in some implementations of the third aspect, the plurality of second code words include at least two second code words whose code rates are different.

According to a fourth aspect, a communication method is provided. The method includes:
receiving a data packet, where the data packet includes a plurality of second code words; and
performing at least one type of second decoding on the plurality of second code words, to obtain a plurality of second code blocks, where the plurality of second code blocks include a second check block, and the second check block is used to check a portion of information in the plurality of second code blocks.

A data packet including a plurality of code words may be decoded to obtain information of any quantity of bits, a code length of each code word meets a preset code length, and the plurality of code words may be decoded separately. Therefore, time consumption of data transmission is reduced. For example, rate matching time may be reduced. In addition, a plurality of code blocks with a smaller code length are checked together. This helps reduce a code length of the check block in the data packet, reduce signaling overheads, and improve communication efficiency.

With reference to the fourth aspect, in some implementations of the fourth aspect, at least a portion of information other than the second check block in the at least one second code block is obtained through check decoding based on the second check block.

With reference to the fourth aspect, in some implementations of the fourth aspect, the plurality of second code blocks include redundant information, and in the plurality of second code blocks, the redundant information is located before or after the second check block, or is located at a front location in a 1^{st} second code block in the plurality of second code blocks.

With reference to the fourth aspect, in some implementations of the fourth aspect, in the plurality of second code blocks, the second check block is located in one or more consecutive code blocks.

With reference to the fourth aspect, in some implementations of the fourth aspect, the data packet includes a second data group, and the second data group includes the plurality of second code words.

With reference to the fourth aspect, in some implementations of the fourth aspect, the method further includes:
sending feedback information corresponding to the second data group.

With reference to the fourth aspect, in some implementations of the fourth aspect, the plurality of second code words include at least two second code words whose code rates are different.

According to a fifth aspect, a communication apparatus is provided, including:
a processing module, configured to generate a data packet, where the data packet includes at least one first code word and at least one second code word, and a code length of the first code word is greater than a code length of the second code word; and
a sending module, configured to send the data packet.

The at least one first code word is obtained by performing first encoding on at least one first code block, each of the at least one first code block includes a first information block and a first check block used to check the first information block, the at least one second code word is obtained by performing at least one type of second encoding on at least one second code block, the at least one second code block includes a second check block, and the second check block is used to check a portion of information in the at least one second code block.

With reference to the fifth aspect, in some implementations of the fifth aspect, the apparatus further includes:
an obtaining module, configured to obtain at least one first information block.

The processing module is further configured to generate a first check block corresponding to each of the at least one first information block.

With reference to the fifth aspect, in some implementations of the fifth aspect, the second check block is generated based on at least a portion of information other than the second check block in the at least one second code block.

With reference to the fifth aspect, in some implementations of the fifth aspect, the at least one second code block includes redundant information, and in the at least one second code block, the redundant information is located before or after the second check block, or is located at a front location in a 1^{st} second code block in the plurality of second code blocks.

With reference to the fifth aspect, in some implementations of the fifth aspect, in the at least one second code block, the second check block is located in one or more consecutive code blocks.

With reference to the fifth aspect, in some implementations of the fifth aspect, the data packet includes L data groups, the L data groups include L₁ first data groups and one second data group, each of the L₁ first data groups includes n first code words, the second data group includes the at least one second code word, and L₁ and n are greater than or equal to 1.

With reference to the fifth aspect, in some implementations of the fifth aspect, the apparatus further includes:
a receiving module, configured to receive L pieces of feedback information corresponding to the data packet, where the L pieces of feedback information correspond to the L data groups.

With reference to the fifth aspect, in some implementations of the fifth aspect, n meets n=ceil(H/(L-1)), and H is a total quantity of the at least one first code word.

With reference to the fifth aspect, in some implementations of the fifth aspect, when mod(H, (L-1))>0, the L data groups further include L₂ third data groups, and each of the L₂ third data groups includes p first code words, where L₂ is a positive integer less than L-L₁, and p meets p=floor(H/(L-1)).

With reference to the fifth aspect, in some implementations of the fifth aspect, L₁ meets L₁=mod(H, (L-1)), and L₂ meets L₂=L-mod(H, (L-1))-1.

With reference to the fifth aspect, in some implementations of the fifth aspect, the at least one first code word has a same code length.

With reference to the fifth aspect, in some implementations of the fifth aspect, the at least one second code word includes at least two second code words whose code rates are different.

With reference to the fifth aspect, in some implementations of the fifth aspect, a code length sum of the at least one second code word is less than the code length of the first code word.

According to a sixth aspect, a communication apparatus is provided, including:
a receiving module, configured to receive a data packet, where the data packet includes at least one first code word and at least one second code word, and a code length of the first code word is greater than a code length of the second code word; and
a processing module, configured to: perform first decoding on the at least one first code word, and perform at least one type of second decoding on the at least one second code word, to obtain at least one first code block and at least one second code block, where each of the at least one first code block includes a first information block and a first check block used to check the first information block, the at least one second code block includes a second check block, and the second check block is used to check a portion of information in the at least one second code block.

With reference to the sixth aspect, in some implementations of the sixth aspect, the first information block in the first code block is obtained through check decoding based on the first check block in the first code block.

With reference to the sixth aspect, in some implementations of the sixth aspect, at least a portion of information other than the second check block in the at least one second code block is obtained through check decoding based on the second check block.

With reference to the sixth aspect, in some implementations of the sixth aspect, the at least one second code block includes redundant information, and in the at least one second code block, the redundant information is located before or after the second check block, or is located at a front location in a 1^{st} second code block in the plurality of second code blocks.

With reference to the sixth aspect, in some implementations of the sixth aspect, in the at least one second code block, the second check block is located in one or more consecutive code blocks.

With reference to the sixth aspect, in some implementations of the sixth aspect, the data packet includes L data groups, the L data groups include L₁ first data groups and one second data group, each of the L₁ first data groups includes n first code words, the second data group includes the at least one second code word, and L₁ and n are greater than or equal to 1.

With reference to the sixth aspect, in some implementations of the sixth aspect, the apparatus further includes:
a sending module, configured to send L pieces of feedback information corresponding to the data packet, where the L pieces of feedback information correspond to the L data groups.

With reference to the sixth aspect, in some implementations of the sixth aspect, n meets n=ceil(H/(L-1)), and H is a total quantity of the at least one first code word.

With reference to the sixth aspect, in some implementations of the sixth aspect, when mod(H, (L-1))>0, the L data groups further include L₂ third data groups, and each of the L₂ third data groups includes p first code words, where L₂ is a positive integer less than L-L₁, and p meets p=floor(H/(L-1)).

With reference to the sixth aspect, in some implementations of the sixth aspect, L₁ meets L₁=mod(H, (L-1)), and L₂ meets L₂=L-mod(H, (L-1))-1.

With reference to the sixth aspect, in some implementations of the sixth aspect, the at least one first code word has a same code length.

With reference to the sixth aspect, in some implementations of the sixth aspect, the at least one second code word includes at least two second code words whose code rates are different.

With reference to the sixth aspect, in some implementations of the sixth aspect, a code length sum of the at least one second code word is less than the code length of the first code word.

According to a seventh aspect, a communication apparatus is provided. The apparatus includes:
a processing module, configured to generate a data packet, where the data packet includes a plurality of second code words; and
a sending module, configured to send the data packet.

The plurality of second code words are obtained by performing at least one type of second encoding on a plurality of second code blocks, the plurality of second code blocks include a second check block, and the second check block is used to check a portion of information in the plurality of second code blocks.

With reference to the seventh aspect, in some implementations of the seventh aspect, the second check block is generated based on at least a portion of information other than the second check block in the at least one second code block.

With reference to the seventh aspect, in some implementations of the seventh aspect, the plurality of second code blocks include redundant information, and in the plurality of second code blocks, the redundant information is located before or after the second check block, or is located at a front location in a 1^{st} second code block in the plurality of second code blocks.

With reference to the seventh aspect, in some implementations of the seventh aspect, in the plurality of second code blocks, the second check block is located in one or more consecutive code blocks.

With reference to the seventh aspect, in some implementations of the seventh aspect, the data packet includes a second data group, and the second data group includes the plurality of second code words.

With reference to the seventh aspect, in some implementations of the seventh aspect, the apparatus further includes:
a receiving module, configured to receive feedback information corresponding to the second data group.

With reference to the seventh aspect, in some implementations of the seventh aspect, the plurality of second code words include at least two second code words whose code rates are different.

According to an eighth aspect, a communication apparatus is provided. The apparatus includes:
a receiving module, configured to receive a data packet, where the data packet includes a plurality of second code words; and
a processing module, configured to perform at least one type of second decoding on the plurality of second code words, to obtain a plurality of second code blocks, where the plurality of second code blocks include a second check block, and the second check block is used to check a portion of information in the plurality of second code blocks.

With reference to the eighth aspect, in some implementations of the eighth aspect, at least a portion of information other than the second check block in the at least one second code block is obtained through check decoding based on the second check block.

With reference to the eighth aspect, in some implementations of the eighth aspect, the plurality of second code blocks include redundant information, and in the plurality of second code blocks, the redundant information is located before or after the second check block, or is located at a front location in a 1^{st} second code block in the plurality of second code blocks.

With reference to the eighth aspect, in some implementations of the eighth aspect, in the plurality of second code blocks, the second check block is located in one or more consecutive code blocks.

With reference to the eighth aspect, in some implementations of the eighth aspect, the data packet includes a second data group, and the second data group includes the plurality of second code words.

With reference to the eighth aspect, in some implementations of the eighth aspect, the apparatus further includes:
a sending module, configured to send feedback information corresponding to the second data group.

With reference to the eighth aspect, in some implementations of the eighth aspect, the plurality of second code words include at least two second code words whose code rates are different.

According to a ninth aspect, a communication apparatus is provided. The communication apparatus includes at least one processor and a communication interface, the communication interface is used by the communication apparatus to exchange information with another communication apparatus, and when program instructions are executed in the at least one processor, the communication apparatus is enabled to implement the communication method according to any one of the first aspect to the fourth aspect or the possible implementations of the first aspect to the fourth aspect.

According to a tenth aspect, a communication device is provided, including a communication apparatus configured to perform any one of the fifth aspect to the eighth aspect or the possible implementations of the fifth aspect to the eighth aspect.

According to an eleventh aspect, a computer program storage medium is provided. The computer-readable medium stores program code, and when the computer program code is run on a computer, the computer is enabled to perform the communication method according to any one of the first aspect to the fourth aspect or the possible implementations of the first aspect to the fourth aspect.

According to a twelfth aspect, a chip system is provided. The chip system includes at least one processor, and when program instructions are executed in the at least one processor, the communication method according to any one of the first aspect to the fourth aspect or the possible implementations of the first aspect to the fourth aspect is implemented.

### BRIEF DESCRIPTION OF DRAWINGS

FIG. 1 is a schematic diagram of a communication scenario according to an embodiment of this application;
FIG. 2 is a schematic diagram of a structure of a data frame;
FIG. 3 is a schematic structural diagram of data retransmission;
FIG. 4 is a schematic flowchart of a communication method according to an embodiment of this application;
FIG. 5 is a schematic diagram of a structure of a data packet according to an embodiment of this application;
FIG. 6 is a schematic structural diagram of encoding a first code block according to an embodiment of this application;
FIG. 7 is a schematic structural diagram of encoding a single second code block according to an embodiment of this application;
FIG. 8 is a schematic structural diagram of encoding a plurality of second code blocks according to an embodiment of this application;
FIG. 9 is another schematic structural diagram of encoding a plurality of second code blocks according to an embodiment of this application;
FIG. 10 is a schematic flowchart of another communication method according to an embodiment of this application;
FIG. 11 is a schematic diagram of a structure of another data packet according to an embodiment of this application;
FIG. 12 is a schematic flowchart of another communication method according to an embodiment of this application;
FIG. 13 is a schematic diagram of a structure of another data packet according to an embodiment of this application;
FIG. 14 is a schematic diagram of a structure of a communication apparatus according to an embodiment of this application; and
FIG. 15 is a schematic diagram of a structure of a communication apparatus according to an embodiment of this application.

### DESCRIPTION OF EMBODIMENTS

The following describes technical solutions of this application with reference to accompanying drawings.

The technical solutions in embodiments of this application may be applied to various communication systems, such as a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, an LTE frequency division duplex (frequency division duplex, FDD) system, LTE time division duplex (time division duplex, TDD), a universal mobile telecommunications system (universal mobile telecommunications system, UMTS), a worldwide interoperability for microwave access (worldwide interoperability for Microwave Access, WiMAX) communication system, a millimeter-wave communication system like a 5th generation (5th generation, 5G) system or new radio (New Radio, NR), a 6th generation (6th generation, 6G) system, various existing short-range communication systems, a future evolved short-range communication system, or a universal short-range communication system.

A terminal device in embodiments of this application may be a communication node, for example, user equipment, an access terminal, a subscriber unit, a subscriber station, a mobile station, a remote station, a remote terminal, a mobile device, a user terminal, a terminal, a wireless communication device, a user agent or a user apparatus, or a customer premises equipment (customer premises equipment). The terminal device may alternatively be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device, a wearable device, a terminal device in a 5G network, a terminal device in an evolved public land mobile network (public land mobile network, PLMN), or the like. For another example, the terminal device may be a terminal device that supports short-range communication. This is not limited in embodiments of this application. The terminal device may alternatively be an intelligent transportation device, for example, a vehicle, an uncrewed aerial vehicle, or a vehicle-mounted chip. The terminal device may alternatively be a smart manufacturing device, for example, an industrial manufacturing system or a battery management system. The terminal device may alternatively be a smart home device, for example, a television, a stereo, a camera, a voice assistant, a smart curtain, or a smart lamp. The terminal device may alternatively be an intelligent terminal device, for example, a mobile phone, a tablet computer, a headset, a watch, a microphone, or a vehicle-mounted device.

A network device in embodiments of this application may be a device configured to communicate with the terminal device, and may also be referred to as a communication node. The communication node may be a base transceiver station (base transceiver station, BTS) in a GSM system or a CDMA system, a NodeB (NodeB, NB) in a WCDMA system, an evolved NodeB (evolved NodeB, eNB or eNodeB) in an LTE system, or a radio controller in a cloud radio access network (cloud radio access network, CRAN) scenario. Alternatively, the network device may be a relay station, an access point, a vehicle-mounted device, a wearable device, a network device in a 5G network, a network device in a future evolved PLMN network, a communication device applicable to a future communication technology such as 6G, or a communication device that supports short-range communication. This is not limited in embodiments of this application. The network device may alternatively be an intelligent transportation device, for example, a vehicle, an uncrewed aerial vehicle, or a vehicle-mounted chip. The network device may alternatively be a smart manufacturing device, for example, an industrial manufacturing system or a battery management system. The network device may alternatively be a smart home device, for example, a television, a stereo, a camera, a voice assistant, a smart curtain, or a smart lamp. The network device may alternatively be an intelligent network device, for example, a mobile phone, a tablet computer, a headset, a watch, a microphone, or a vehicle-mounted device.

In embodiments of this application, the terminal device or the network device includes a hardware layer, an operating system layer running on the hardware layer, and an application layer running on the operating system layer. The hardware layer includes hardware such as a central processing unit (central processing unit, CPU), a memory management unit (memory management unit, MMU), and a memory (also referred to as a main memory). The operating system may be any one or more computer operating systems that implement service processing by using a process (process), for example, a Harmony operating system, a Linux operating system, a Unix operating system, an Android operating system, an iOS operating system, or a Windows operating system. The application layer includes applications such as a browser, contacts, word processing software, and instant messaging software. In addition, a specific structure of an execution body of a method provided in embodiments of this application is not particularly limited in embodiments of this application, provided that a program that records code of the method provided in embodiments of this application can be run to perform communication according to the method provided in embodiments of this application. For example, the execution body of the method provided in embodiments of this application may be the terminal device or the network device, or a functional module that can invoke and execute the program in the terminal device or the network device.

In addition, aspects or features of this application may be implemented as a method, an apparatus, or a product that uses standard programming and/or engineering technologies. The term "product" used in this application covers a computer program that can be accessed from any computer-readable component, carrier or medium. For example, a computer-readable medium may include but is not limited to: a magnetic storage device (for example, a hard disk, a floppy disk or a magnetic tape), an optical disc (for example, a compact disc (compact disc, CD) and a digital versatile disc (digital versatile disc, DVD)), a smart card, and a flash memory component (for example, an erasable programmable read-only memory (erasable programmable read-only memory, EPROM), a card, a stick, or a key drive). In addition, various storage media described in this specification may indicate one or more devices and/or other machine-readable media that are configured to store information. The term "machine-readable media" may include but is not limited to a radio channel, and various other media that can store, contain, and/or carry instructions and/or data.

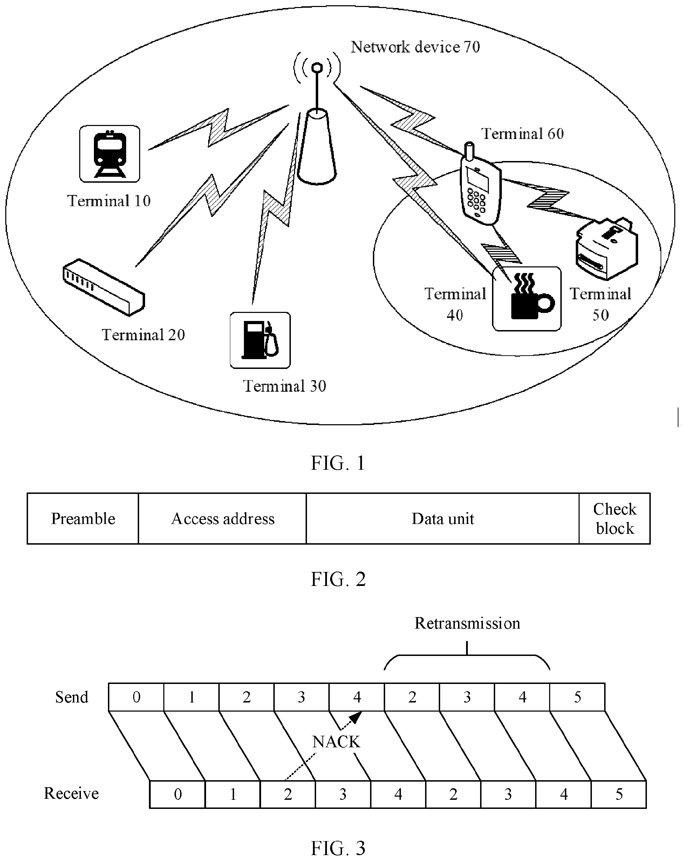

FIG. 1 is a schematic diagram of a communication system according to this application. The communication system in FIG. 1 may include at least one terminal (for example, a terminal 10, a terminal 20, a terminal 30, a terminal 40, a terminal 50, and a terminal 60) and a network device 70. The network device 70 is configured to provide a communication service for the terminal and access a core network. The terminal may access a network by searching for a synchronization signal, a broadcast signal, or the like sent by the network device 70, to communicate with the network. The terminal 10, the terminal 20, the terminal 30, the terminal 40, and the terminal 60 in FIG. 1 may perform uplink and downlink transmission with the network device 70. For example, the network device 70 may send downlink signals to the terminal 10, the terminal 20, the terminal 30, the terminal 40, and the terminal 60, and may receive uplink signals sent by the terminal 10, the terminal 20, the terminal 30, the terminal 40, and the terminal 60.

In addition, the terminal 40, the terminal 50, and the terminal 60 may also be considered as a communication system. The terminal 60 may send downlink signals to the terminal 40 and the terminal 50, and may receive uplink signals sent by the terminal 40 and the terminal 50.

It should be noted that embodiments of this application may be applied to a communication system including one or more network devices, or may be applied to a communication system including one or more terminals. This is not limited in this application.

It should be understood that the communication system may include one or more network devices. One network device may send data or control signaling to one or more terminals. A plurality of network devices may simultaneously send data or control signaling to one or more terminals.

FIG. 2 is a schematic diagram of a structure of a data frame. The data frame shown in FIG. 2 may be sent by a sending device to a receiving device. In a possible example, one of the sending device and the receiving device may be a terminal device, and the other may be a network device. In another possible example, both the sending device and the receiving device may be terminal devices. In another possible example, both the sending device and the receiving device may be network devices.

The data frame may include a preamble, an access address, a data unit (for example, a protocol data unit (protocol data unit, PDU)), and a check block (cyclic redundancy check, CRC). For example, the preamble may be used to implement frequency synchronization, symbol timing synchronization (symbol timing estimation, STE), automatic gain control (automatic gain control, AGC), and the like. The access address may indicate, for example, an address of the receiving device. The data unit may include, for example, a header and valid data (or referred to as a payload (payload)). The header may indicate, for example, a type of the data unit, a type of a device address for sending the data, a type of a device address for receiving the data, a quantity of bytes of the valid data, and the like. The check block is used to check the data unit. For example, the sending device may generate the check block based on the data unit. The receiving device may check, based on the check block, whether the data unit is incorrect.

Optionally, the data frame may further include a connection interval (connection interval, CI), an algorithm terminator (termination, TERM), and the like.

The sending device may determine information to be sent to the receiving device. The sending device may encode the information at a code rate, to obtain an encoded code stream. To match a bearer capability of a physical channel, the sending device needs to perform rate matching on the encoded code stream. It can be learned from this that the sending device can send data to the receiving device only when the sending device includes at least an encoding module and a rate matching module.

FIG. 3 is a schematic structural diagram of retransmission of the data frame shown in FIG. 2.

The sending device may determine a plurality of data frames to be sent to the receiving device. The data frame may be of a data structure including a data unit and a check block. The sending device may send the plurality of data frames to the receiving device. Correspondingly, the receiving device may receive the plurality of data frames from the sending device, and check each data frame.

If the receiving device correctly receives a data frame from the sending device, the receiving device may send an acknowledgment (acknowledge character, ACK) message to the sending device, where the acknowledgment message may indicate that the receiving device correctly receives the data frame sent by the sending device. After receiving the acknowledgment message from the receiving device, the sending device may continue to send a subsequent data frame.

If the receiving device does not correctly receive a data frame from the sending device, the receiving device may send a negative acknowledgment (negative acknowledge character, NACK) message to the sending device, where the negative acknowledgment message may indicate that the receiving device does not correctly receive the data frame sent by the sending device. The sending device receives the negative acknowledgment message from the receiving device, and may resend the data frame that is incorrectly transmitted.

If the sending device does not receive the acknowledgment message or the negative acknowledgment message from the receiving device within a period of time, the sending device may resend the data frame to the receiving device.

For example, as shown in FIG. 3, the sending device may determine the plurality of data frames that are to be sent to the receiving device, and the plurality of data frames may include a data frame 0, a data frame 1, a data frame 2, a data frame 3, and a data frame 4. The sending device may send the data frame 0, the data frame 1, the data frame 2, the data frame 3, and the data frame 4 to the receiving device. The receiving device may receive the data frame 0, the data frame 1, the data frame 2, the data frame 3, and the data frame 4 from the sending device, and separately check the data frame 0, the data frame 1, and the data frame 2. In the example shown in FIG. 3, the receiving device may correctly receive the data frame 0 and the data frame 1 from the sending device, and incorrectly receive the data frame 2. Because the data frame 2 is not correctly received, the receiving device may not check the received data frame 3 and data frame 4. The receiving device may send an acknowledgment message for the data frame 0 and the data frame 1 and a negative acknowledgment message for the data frame 2 to the sending device. The sending device may resend the data frame 2, the data frame 3, and the data frame 4 to the receiving device based on the negative acknowledgment message for the data frame 2.

It can be learned from the example shown in FIG. 3 that the receiving device may correctly receive the data frame 3 and the data frame 4. When the receiving device correctly receives the data frame 3 and the data frame 4, the sending device may send the data frame 3 and the data frame 4 to the receiving device at least twice, resulting in low communication efficiency.

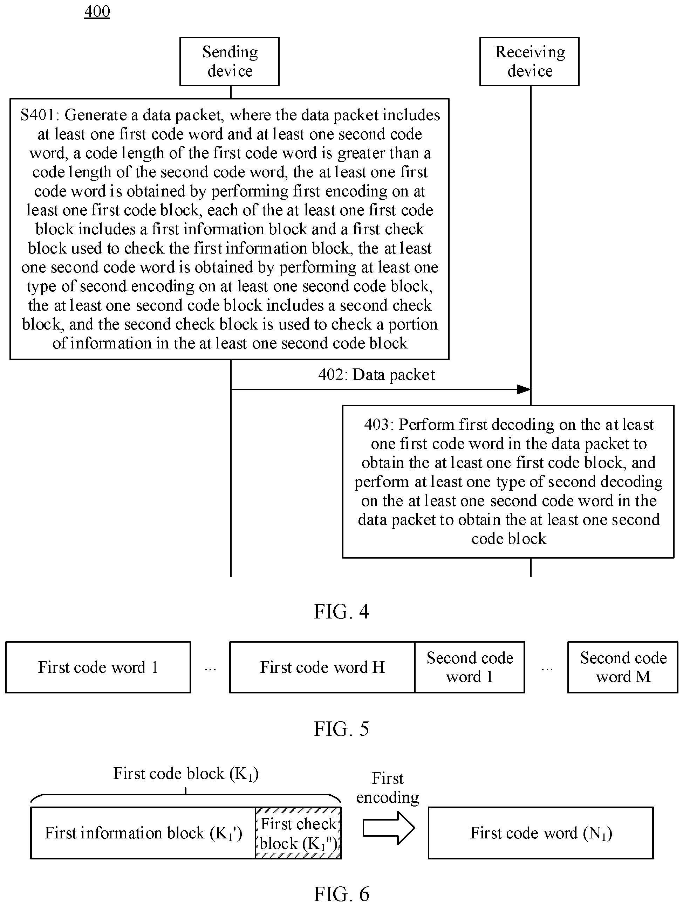

FIG. 4 is a schematic flowchart of a communication method 400 according to an embodiment of this application.

401: A sending device generates a data packet, where the data packet includes at least one first code word and at least one second code word, a code length of the first code word is greater than a code length of the second code word, the at least one first code word is obtained by performing first encoding on at least one first code block, each of the at least one first code block includes a first information block and a first check block used to check the first information block, the at least one second code word is obtained by performing at least one type of second encoding on at least one second code block, the at least one second code block includes a second check block, and the second check block is used to check a portion of information in the at least one second code block.

402: The sending device sends the data packet.

Correspondingly, a receiving device receives the data packet from the sending device.

403: The receiving device performs first decoding on the at least one first code word in the data packet to obtain the at least one first code block, and the receiving device may perform at least one type of second decoding on the at least one second code word in the data packet to obtain the at least one second code block.

It should be understood that the method shown in FIG. 4 may be performed by an electronic device having a communication function. For example, the sending device may be a terminal device, and the receiving device may be a network device. For another example, the sending device may be a network device, and the receiving device may be a terminal device. For another example, the sending device may be a terminal device 1, and the receiving device may be a terminal device 2.

FIG. 5 shows a structure of the data packet.

In an example shown in FIG. 5, the data packet may include H first code words and M second code words. It should be understood that the data packet may include more or fewer first code words, or may include more or fewer second code words. For example, the data packet may include only one first code word and one second code word.

Optionally, the sending device obtains at least one first information block, and the sending device generates at least one first check block in the at least one first code block, where the first check block corresponds to a first information block in a first code block in which the first check block is located. A manner of generating the at least one first code block may include, for example, check encoding such as cyclic redundancy check (cyclic redundancy check, CRC) encoding.

Optionally, the first information block in the first code block is obtained through check decoding (for example, CRC decoding) based on at least the first check block in the first code block. In an example, the receiving device may input the first information block and the first check block into a check polynomial. If a result of the check polynomial is zero, the first information block is successfully checked.

Optionally, the first code block may include redundant information (a description of the redundant information is described in detail below). The first information block in the first code block may be obtained by performing a redundancy removal operation and performing check decoding (for example, CRC decoding) based on the first check block in the first code block.

For example, the redundant information may be located after the first check block. After removing the redundant information from the first code block, the receiving device may input the first information block and the first check block into the check polynomial. If a result of the check polynomial is zero, the first information block is successfully checked.

For another example, the redundant information may be located before the first check block. The receiving device may input the first information block, the redundant information, and the first check block into the check polynomial. If a result of the check polynomial is zero, the first information block and the redundant information are successfully checked. Then, the receiving device may remove the redundant information to obtain the first information block.

For another example, the redundant information may be located before the first information block in the first code block (or located at a start part of the first code block). The receiving device may input the redundant information, the first information block, and the first check block into the check polynomial. If a result of the check polynomial is zero, the first information block and the redundant information are successfully checked. Then, the receiving device may remove the redundant information to obtain the first information block. With reference to FIG. 6, the following describes an example of performing first encoding on the first code block.

As shown in FIG. 6, the sending device may obtain the first code block, and the first code block may include the first information block and the first check block. The first information block and the first check block in the first code block correspond to each other. Specifically, the first check block may be used to check the corresponding first information block. In other words, the first check block may be used to check the first information block in the first code block in which the first check block is located. The sending device may generate the corresponding first check block based on the first information block. The sending device may perform first encoding on the first code block to obtain the first code word.

The receiving device performs first decoding on the first code word in the data packet, to obtain the first code block. The first code block may include the first information block and the first check block. The receiving device may check, based on the first check block, whether the first information block in the first code block in which the first check block is located is correct, to determine to feed back an acknowledgment message or a negative acknowledgment message to the sending device. The sending device may determine, based on feedback of the receiving device, whether to retransmit the first code word.

The data packet may include a plurality of first code words. Before generating the plurality of first code words, the sending device may obtain a plurality of first information blocks. The sending device may perform check encoding on each of the plurality of first information blocks, to obtain a plurality of first check blocks, where the plurality of first check blocks are in a one-to-one correspondence with the plurality of first information blocks. Any first check block may be concatenated with a corresponding first information block. Any first check block may be located after a corresponding first information block. Any first check block and a corresponding first information block may form a first code block. The plurality of first information blocks and the plurality of first check blocks may constitute a plurality of first code blocks, so that the sending device may obtain the plurality of first code blocks. A first check block in an upper-level first code block may be concatenated with a first information block in a lower-level first code block. The first information block in the lower-level first code block may be located after the first check block in the upper-level first code block. Refer to the example shown in FIG. 6. The sending device may perform first encoding on each of the plurality of first code blocks (first encoding may be performed on the plurality of first code blocks synchronously or sequentially), to obtain the plurality of first code words. A quantity of bits in the first information block may be K₁', and a quantity of bits in the first check block may be K₁". In an example, a quantity of bits in the first code block may be K₁, and K₁≥K₁'+K₁". First encoding is performed on the first code block to obtain the first code word, and a code length (or a quantity of bits) of the first code word may be N₁. A code rate of the first encoding may be K₁/N₁.

With reference to FIG. 5 and FIG. 6, the data packet may include the plurality of first code words. Before generating the plurality of first code words, the sending device may obtain the plurality of first code blocks, and the plurality of first code blocks may be in a one-to-one correspondence with the plurality of first code words. The sending device may perform first coding on each first code block. In an example, a code length of each first code word may be the same, a quantity of bits of each first code block may be the same, and a code rate of the first encoding at each time may be the same. Encoding of a same type may be performed on the plurality of first code blocks, to generate the plurality of first code words. In a possible example, the first encoding may be, for example, polar code (Polar code or the like) encoding. For a decoding process of the plurality of first code words, refer to the encoding process of the plurality of first code blocks. Details are not described herein again.

Optionally, the second check block is generated based on at least a portion of information other than the second check block in the at least one second code block. A manner of generating the at least one second code block may include, for example, check encoding, for example, CRC encoding. Optionally, when the at least one second code block includes a plurality of second code blocks, the manner of generating the at least one second code block may further include data segmentation, to form the plurality of second code blocks. Optionally, the manner of generating the at least one second code block may further include a redundancy addition operation. In other words, the at least one second code block may include redundant information.

Optionally, at least the portion of information other than the second check block in the at least one second code block is obtained through check decoding (for example, CRC decoding) based on the second check block. In an example, the receiving device may input the at least one second code block into the check polynomial. If a result of the check polynomial is zero, the first information block is successfully checked.

Optionally, the at least one second code block may include the redundant information. At least the portion of information other than the second check block in the at least one second code block may be obtained by performing a redundancy removal operation and performing check decoding based on the second check block.

For example, the redundant information may be located after the second check block. After removing the redundant information from the at least one second code block, the receiving device may input information other than the redundant information in the at least one second code block into the check polynomial. If a result of the check polynomial is zero, the information other than the second check block and the redundant information in the at least one second code block is successfully checked.

For another example, the redundant information may be located before the second check block. The receiving device may input all information (including the second check block and the redundant information) in the at least one second code block into the check polynomial. If a result of the check polynomial is zero, the information in the at least one second code block is successfully checked. Then, the receiving device may remove the redundant information, to obtain information other than the second check block and the redundant information in the at least one second code block.

For another example, the redundant information may be located at a front location in a 1^{st} second code block in the at least one second code block (or located at a start part of the at least one second code block). The receiving device may input all information in the at least one second code block into the check polynomial. If a result of the check polynomial is zero, the check succeeds. Then, the receiving device may remove the redundant information, to obtain information other than the second check block and the redundant information in the at least one second code block.

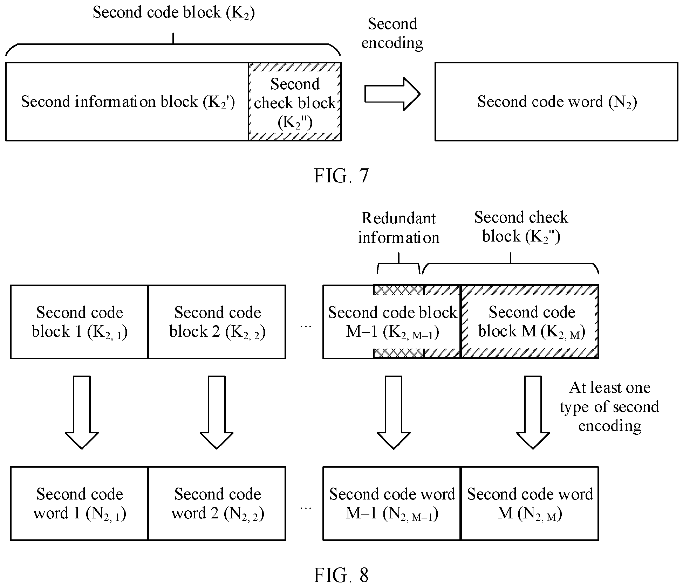

With reference to FIG. 7, the following describes an example of performing at least one type of second encoding on the at least one second code block. In the example shown in FIG. 7, the data packet may include a single second code word.

The sending device may obtain a single second code block, and the single second code block may include a second information block and a second check block. The second information block and the second check block in the single second code block correspond to each other. The second check block may be used to check the corresponding second information block. The sending device may generate the corresponding second check block based on the second information block. The sending device may perform second encoding on the single second code block to obtain the single second code word.

The receiving device performs second decoding on the single second code word in the data packet, to obtain the second code block, where the second code block may include the second information block and the second check block. The receiving device may check, based on the second check block, whether the second information block corresponding to the second check block is correct, to determine to feed back an acknowledgment message or a negative acknowledgment message to the sending device. The sending device may determine, based on feedback of the receiving device, whether to retransmit the single second code word.

Optionally, the single second code word includes redundant information, and in the single second code word, the redundant information is located before or after the second check block, or before the second information block. If the redundant information is located before the second check block, the second check block may be used to check the redundant information. If the redundant information is located after the second check block, the second check block may not be used to check the redundant information. For example, the second check block may be irrelevant to the redundant information.

The redundant information may be information other than minimum limit information required for information transmission. In an example, values of all information bits of the redundant information may be, for example, 0 or 1. That the redundant information is located before the second check block may mean that a location of the redundant information in the single second code block is before a location of the second check block. That the redundant information is located after the second check block may mean that a location of the redundant information in the single second code block is after a location of the second check block. That the redundant information is located before the second information block may mean that a location of the redundant information in the single second code block is before a location of the second information block.

A quantity of bits in the second information block may be K₂', and a quantity of bits in the second check block may be K₂". In an example, a quantity of bits in the second code block may be K₂, and K₂≥K₂'+K₂". For example, the second code block may include the redundant information, a quantity of bits of the redundant information may be K₂‴, and K₂=K₂'+K₂"+K₂‴. Second encoding is performed on the second code block to obtain the second code word, and a code length (or a quantity of bits) of the second code word may be N₂. A code rate of the second encoding may be K₂/N₂.

When the data packet includes the single second code word, the code length of the single second code word may be less than the code length of the first code word. The quantity of bits in the second code block may be different from the quantity of bits in the first code block. The code rate of the first encoding may be the same as or different from the code rate of the second encoding.

For example, the quantity of bits in the first code block is 1000, the code length of the first code word is 1024, and the code rate of the first encoding may be 1000/1024. The quantity of bits of the second code block is 400, the code length of the second code word is 512, and the code rate of the second encoding may be 400/512.

For another example, the quantity of bits in the first code block is 1000, the code length of the first code word is 1024, and the code rate of the first encoding may be 1000/1024. The quantity of bits of the second code block is 500, the code length of the second code word is 512, and the code rate of the second encoding may be 500/512.

For another example, the quantity of bits in the first code block is 1000, the code length of the first code word is 1024, and the code rate of the first encoding may be 1000/1024. The quantity of bits of the second code block is 60, the code length of the second code word is 128, and the code rate of the second encoding may be 60/128.

For a decoding process of the single second code word, refer to the encoding process of the single second code block. Details are not described herein again.

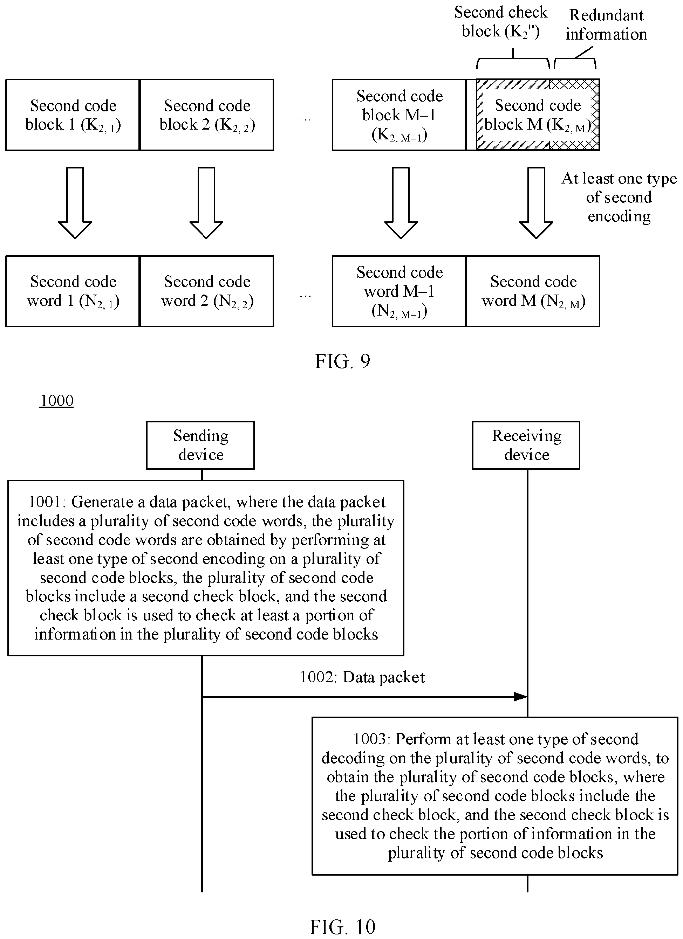

With reference to FIG. 8 and FIG. 9, the following describes another example of performing at least one type of second encoding on the at least one second code block. In the example shown in FIG. 8 and FIG. 9, the data packet may include a plurality of second code words.

The sending device may obtain a plurality of second code blocks. As shown in FIG. 8 and FIG. 9, the plurality of second code blocks may include a second code block 1, a second code block 2, ..., a second code block M-1, and a second code block M. The plurality of second code blocks may include a second check block. Optionally, in the at least one second code block, the second check block is located in one or more consecutive code blocks. In other words, the second check block may be located in one of the plurality of second code blocks, or the second check block may be located in a plurality of consecutive code blocks in the plurality of second code blocks. As shown in FIG. 8 and FIG. 9, the second check block may be shown by a pattern filled with slashes. The plurality of consecutive code blocks may mean that locations of the plurality of code blocks are consecutive. For example, the plurality of consecutive code blocks include K code blocks, which are respectively a code block 1, a code block 2, ..., a code block K-1, and a code block K. A location of a code block k is adjacent to a location of a code block k-1, the location of the code block k is adjacent to a location of a code block k+1, and k ∈ (1, K). Two adjacent code blocks may be concatenated. For example, a header of the code block k may be concatenated with a tail of the code block k-1, and a tail of the code block k may be concatenated with a header of the code block k+1.

In the example shown in FIG. 8, a first portion of the second check block may belong to the second code block M-1, and a second portion of the second check block may belong to the second code block M. The second code block M-1 and the second code block M may be adjacent. It is assumed that a quantity of bits of the second code block M-1 may be K₂, _{M-1}, a quantity of bits of the second code block M may be K_{2, M}, a quantity of bits of the second check block may be K₂", and K₂, _{M}≤K₂"≤K_{2, M-1}+K_{2, M}.

In the example shown in FIG. 9, the second check block may belong to the second code block M. It is assumed that a quantity of bits in the second code block M may be K_{2, M}, a quantity of bits in the second check block may be K₂", and K₂" ≤ K_{2, M}.

The second check block may be used to check at least a portion of information other than the second check block in the plurality of second code blocks.

Optionally, the at least one second code block includes the redundant information, and in the at least one second code block, the redundant information is located before or after the second check block, or is located at a front location in a 1^{st} second code block in the at least one second code block.

In the example shown in FIG. 8, the second check block may be used to check all information in the plurality of second code blocks except the second check block. In other words, all the information in the plurality of second code blocks except the second check block may be located before the second check blocks. The second check block may be generated by the sending device based on all the information in the plurality of second code blocks except the second check block. Correspondingly, the second check block is checked, so that the receiving device may determine whether all the information in the plurality of second code blocks except the second check block is correctly received, to determine to feed back an acknowledgment message or a negative acknowledgment message to the sending device. The sending device may determine, based on feedback of the receiving device, whether to retransmit the plurality of second code words.

Optionally, all the information in the plurality of second code blocks except the second check block may include the redundant information, and the redundant information may be located before the second check block. As shown in FIG. 8, the redundant information may be shown by a pattern filled with diamonds. In other words, when the plurality of second code blocks further include the redundant information, the second check block may be used to check the redundant information. That the redundant information is located before the second check block may mean that a location of the redundant information in the plurality of second code blocks is before a location of the second check block.

In the example shown in FIG. 9, the second check block may be used to check a portion of information other than the second check block in the plurality of second code blocks. In other words, all information in the plurality of second code blocks except the second check block may include a first portion of the information and a second portion of the information. The first portion of the information may be located before the second check block, and the second portion of the information may be located after the second check block. The second check block may be used to check the first portion of the information, and is not used to check the second portion of the information. The second check block may be generated by the sending device based on the first portion of the information. Generation of the second check block may not be related to the second portion of the information. Correspondingly, the second check block is checked, so that the receiving device may determine whether the first portion of the information is correctly received, to determine to feed back an acknowledgment message or a negative acknowledgment message to the sending device. The sending device may determine, based on feedback of the receiving device, whether to retransmit the plurality of second code words.

In a possible example, the second portion of the information may be the redundant information. Regardless of whether the redundant information is correctly received, normal communication between the sending device and the receiving device is not affected.

Optionally, all the information in the plurality of second code blocks except the second check block may include the redundant information, and the redundant information may be located after the second check block. As shown in FIG. 9, the redundant information may be shown by a pattern filled with diamonds. In other words, the second check block may not be used to check the redundant information after the second check block. That the redundant information is located after the second check block may mean that a location of the redundant information in the plurality of second code blocks is after a location of the second check block.

Optionally, the redundant information may alternatively be located at a front location in a 1^{st} second code block in the plurality of second code blocks.

It should be understood that the foregoing several types of redundant information locations are merely some possible examples. In an actual operation, padding may be performed at another location.

For example, the redundant information may alternatively be located at a front location in any other first code block, or before the first check block, or after the first check block; or the redundant information may be dispersedly padded into a plurality of first code blocks, and a padded location in each first code block is not limited.

For another example, the redundant information may alternatively be located at a front location in any other second code block, or before the second check block, or after the second check block; or the redundant information may be dispersedly padded into a plurality of second code blocks, and a padded location in each second code block is not limited. Examples are not enumerated one by one herein.

The sending device may perform at least one type of second encoding on the plurality of second code blocks to obtain the plurality of second code words. Correspondingly, the receiving device performs at least one type of second decoding on the plurality of second code words in the data packet, to obtain the plurality of second code blocks. Optionally, the at least one second code word includes at least two second code words whose code rates are different. The following describes an encoding process of the plurality of second code blocks by using some examples.

It is assumed that the plurality of second code blocks may include a second code block i and a second code block j. A quantity of bits in the second code block i may be K_{2, i}, and a quantity of bits in the second code block j may be K_{2,j}. The sending device performs at least one type of second encoding on the plurality of second code blocks to obtain the plurality of second code words. The plurality of second code words may be in a one-to-one correspondence with the plurality of second code blocks. The plurality of second code words may include a second code word i and a second code word j. The second code word i may correspond to the second code block i. In other words, the second code word i may be obtained by performing second encoding on the second code block i. The second code word j may correspond to the second code block j. In other words, the second code word j may be obtained by performing second encoding on the second code block j. A code length of the second code word i may be N_{2, i}, and a code length of the second code word j may be N_{2, j}.

In an example, the quantity K_{2, i} of bits of the second code block i may be the same as the quantity K_{2, j} of bits of the second code block j. If second encoding of a same type is performed on the second code block i and the second code block j, the code length N_{2, i} of the second code word i may be the same as the code length N_{2, j} of the second code word j. A code rate of the second encoding of the same type may be K₂, ᵢ/N_{2, i}=K_{2, j}/N_{2, j}.

In another example, the quantity K_{2, i} of bits of the second code block i may be the same as the quantity K_{2, j} of bits of the second code block j. Second encoding i is performed on the second code block i, and second encoding j is performed on the second code block j, where the second encoding i and the second encoding j are encoding of different types. In this case, the code length N_{2, i} of the second code word i may be different from the code length N_{2, j} of the second code word j. A code rate of the second encoding i may be K_{2, i}/N_{2, i}, and a code rate of the second encoding j may be K_{2, j}/N_{2, j}. K_{2, i}/N_{2, i}≠K_{2, j}/N_{2, j}.

In another example, the quantity K_{2, i} of bits of the second code block i may be different from the quantity K_{2, j} of bits of the second code block j. Second encoding i is performed on the second code block i, and second encoding j is performed on the second code block j, where the second encoding i and the second encoding j are encoding of different types. In this case, the code length N_{2, i} of the second code word i may be the same as or different from the code length N_{2, j} of the second code word j. A code rate of the second encoding i may be K_{2, i}/N_{2, i}, and a code rate of the second encoding j may be K_{2, j}/N_{2, j}. K_{2, i}/N_{2, i} may be the same as or different from K_{2, j}/N_{2, j}.

For a decoding process of the plurality of second code words, refer to the encoding process of the plurality of second code blocks. Details are not described herein again.

Optionally, the at least one first code word has a same code length.

With reference to FIG. 4 to FIG. 9, the data packet may include H first code words whose code lengths each are N₁ and M second code words, and code lengths of the M second code words may be respectively N_{2, 1}, N_{2, 2}, ..., N_{2, M-1}, and N_{2, M}.

In an example, N₁>N₂, ₁+N_{2, 2}+...+N_{2, M-1}+N_{2, M}. For example, the code length N₁ of the first code word may be 1024, and the M second code words may include one second code word whose code length is 64 and one second code word whose code length is 128.

In another example, N₁=N_{2, 1}+N_{2, 2}+...+N_{2, M-1}+N_{2, M}. For example, the code length N₁ of the first code word may be 1024, and the M second code words may include one second code word whose code length is 512 and two second code words whose code lengths each are 256.

In another example, N₁<N_{2, 1}+N_{2, 2}+...+N_{2, M-1}+N_{2, M}. For example, the code length N₁ of the first code word may be 1024, and the M second code words may include two second code words whose code lengths each are 512 and one second code word whose code length is 256.

Optionally, a code length sum of the at least one second code word is less than the code length of the first code word.

Optionally, the plurality of second code words may be arranged in a sequence of code length values. For example, N_{2, 1}>N_{2, 2}>...>N₂, _{M-1}>N_{2, M}, where N_{2, i} may be the code length of the second code word i, and i ∈ [1, M].

Optionally, the sending device may group the plurality of code words in the data packet. Correspondingly, the receiving device may send a feedback message to the sending device based on grouping of the data packet. The sending device may determine, based on the feedback message sent by the receiving device, whether to resend the code words in the data packet. A quantity of groups of the data packet may be configured by using higher layer signaling. The higher layer signaling may be, for example, one or more of broadcast information, a system message, higher layer configuration signaling, media access control layer signaling, or the like.

The following describes several grouping solutions for the data packet.

The data packet may include H first code words and M second code words, and both H and M may be positive integers. The data packet may be divided into L data groups, and L is an integer greater than 1.

Optionally, the data packet includes L data groups, the L data groups include L₁ first data groups and one second data group, each of the L₁ first data groups includes n first code words, the second data group includes the at least one second code word, and L₁ and n are greater than or equal to 1.

In a possible grouping solution, the H first code words in the data packet may be divided into L₁ first data groups, and the M second code words may be divided into a second data group.

Optionally, n meets n=ceil(H/(L-1)), and H is a total quantity of the at least one first code word.

In a possible example, if mod(H, (L-1))=0, the data packet may be divided into L₁ first data groups and one second data group, where L₁=L-1. Each of the L₁ first data groups includes n first code words, and n=H/(L-1). The one second data group may include the M second code words.

For example, if H=1, M=2, and L=2, the data packet may be divided into one first data group and one second data group. The one first data group may include one first code word, and the one second data group may include two second code words.

For another example, if H=4, M=2, and L=3, the data packet may be divided into two first data groups and one second data group. Each of the two first data groups may include two first code words, and the one second data group may include two second code words.

In another possible grouping solution, the H first code words in the data packet may be divided into L₁ first data groups and L₂ third data groups, and the M second code words may be divided into a second data group.

Optionally, when mod(H, (L-1))>0, the L data groups further include L₂ third data groups, and each of the L₂ third data groups includes p first code words, where L₂ is a positive integer less than L-L₁, and p meets p=floor(H/(L-1)).

Optionally, L₁ meets L₁=mod(H, (L-1)), and L₂ meets L₂=L-mod(H, (L-1))-1.

In a possible example, if mod(H, (L-1))>0, the data packet may be divided into L₁ first data groups, one second data group, and L₂ third data groups. L₁=mod(N, (L-1)), and L₂=L-mod(N, (L-1))-1. Each of the L₁ first data groups includes n first code words, and n=ceil(N/(L-1)). The one second data group may include the M second code words. Each of the L₂ third data groups may include p third code words, and p=floor(N/(L-1)).

For example, if H=5, M=2, and L=4, the data packet may be divided into two first data groups, one second data group, and one third data group. Each of the two first data groups may include two first code words, the one second data group may include two second code words, and the one third data group may include one first code word.

The receiving device may receive the data packet sent by the sending device, and decode the data packet to obtain the plurality of code blocks. The receiving device may check each check block in the plurality of code blocks. For example, the receiving device may check H first information blocks in H first code blocks based on H first check blocks in the H first code blocks; and the receiving device may check at least a portion of information in M second code blocks based on a second check block in the M second code blocks.

Because the data packet may be divided into the L data groups, the receiving device may send L pieces of feedback information to the sending device for the L data groups.

Optionally, the sending device receives the L pieces of feedback information corresponding to the data packet, where the L pieces of feedback information correspond to the L data groups. Correspondingly, for a receiving party, the receiving device sends the L pieces of feedback information corresponding to the data packet, where the L pieces of feedback information correspond to the L data groups.

A target first data group in the L₁ first data groups may include n first code words. The receiving device may obtain n first code blocks by decoding the n first code words. If n first check blocks in the n first code blocks are all successfully checked, the receiving device may send first feedback information to the sending device for the target first data group. The first feedback information may indicate that the receiving device correctly receives data in the target first data group. If there is a check block that fails to be checked in n first check blocks in the n first code blocks, the receiving device may send second feedback information to the sending device for the target first data group. The second feedback information may indicate that the receiving device incorrectly receives data in the target first data group. Correspondingly, the sending device may resend at least a portion of the data in the target first data group to the receiving device.

The second data group in the L data groups may include the M second code words. The receiving device may decode the M second code words to obtain the M second code blocks. If the second check block in the M second code blocks is successfully checked, the receiving device may send third feedback information to the sending device for the second data group. The third feedback information may indicate that the receiving device correctly receives data in the second data group. If the second check block in the M second code blocks fails to be checked, the receiving device may send fourth feedback information to the sending device for the second data group. The fourth feedback information may indicate that the receiving device incorrectly receives data in the second data group. Correspondingly, the sending device may resend at least a portion of the data in the second data group to the receiving device.

A target third data group in the L₂ third data groups may include p first code words. The receiving device may obtain p first code blocks by decoding the p first code words. If p first check blocks in the p first code blocks are all successfully checked, the receiving device may send fifth feedback information to the sending device for the target third data group. The fifth feedback information may indicate that the receiving device correctly receives data in the target third data group. If there is a check block that fails to be checked in p first check blocks in the p first code blocks, the receiving device may send sixth feedback information to the sending device for the target third data group. The sixth feedback information may indicate that the receiving device incorrectly receives data in the target third data group. Correspondingly, the sending device may resend at least a portion of the data in the target third data group to the receiving device.

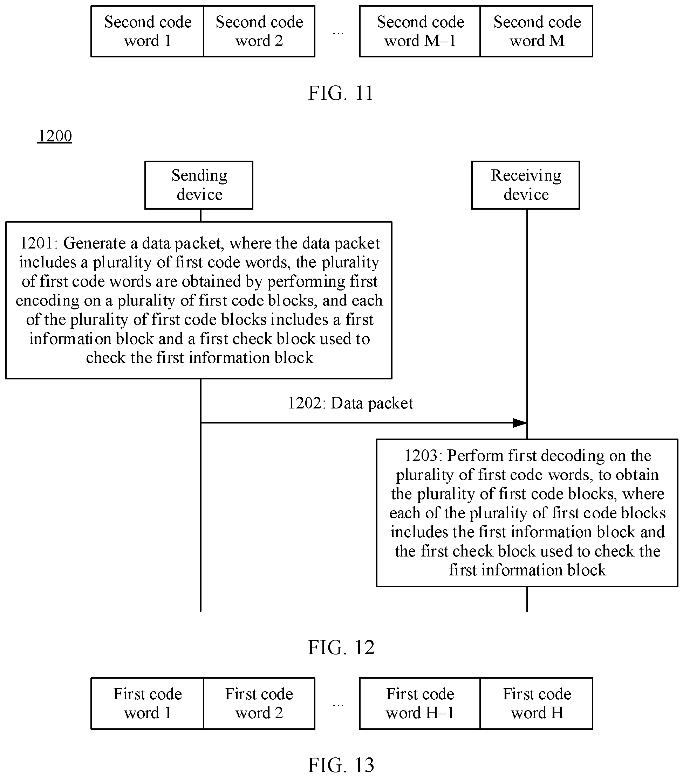

FIG. 10 is a schematic flowchart of another communication method 1000 according to an embodiment of this application. The communication method 1000 shown in FIG. 10 is slightly different from the communication method 400 shown in FIG. 4. The following describes the communication method 1000 with reference to FIG. 10 and FIG. 11.

1001: A sending device generates a data packet, where the data packet includes a plurality of second code words, the plurality of second code words are obtained by performing at least one type of second encoding on a plurality of second code blocks, the plurality of second code blocks include a second check block, and the second check block is used to check at least a portion of information in the plurality of second code blocks.

FIG. 11 shows a structure of a data packet. The data packet shown in FIG. 11 may be the data packet generated by the sending device in 1001.

In the example shown in FIG. 11, the data packet may include M second code words, and M is an integer greater than 1. Different from the data packet shown in FIG. 5, the data packet shown in FIG. 11 may not include a first code word.

Optionally, the second check block is generated based on at least a portion of information other than the second check block in the at least one second code block. A manner of generating the at least one second code block may include, for example, check encoding, for example, CRC encoding.

For a specific implementation of performing at least one type of second encoding on the plurality of second code blocks, refer to the examples shown in FIG. 8 and FIG. 9. Details are not described herein again.

1002: The sending device sends the data packet.

Correspondingly, a receiving device receives the data packet from the sending device.

1003: The receiving device performs at least one type of second decoding on the plurality of second code words, to obtain the plurality of second code blocks, where the plurality of second code blocks include the second check block, and the second check block is used to check the portion of information in the plurality of second code blocks.

For a specific implementation in which the receiving device performs at least one type of second decoding on the plurality of second code words, refer to the examples shown in FIG. 4 to FIG. 9. Details are not described herein again.

Optionally, at least a portion of information other than the second check block in the at least one second code block is obtained through check decoding based on at least the second check block. The receiving device may perform check decoding (for example, CRC decoding) on the at least one second code block, to obtain at least the portion of information other than the second check block in the at least one second code block.

It should be understood that the method shown in FIG. 10 may be performed by an electronic device having a communication function. For example, the sending device may be a terminal device, and the receiving device may be a network device. For another example, the sending device may be a network device, and the receiving device may be a terminal device. For another example, the sending device may be a terminal device 1, and the receiving device may be a terminal device 2.

Optionally, the plurality of second code blocks include redundant information, and in the plurality of second code blocks, the redundant information is located before or after the second check block, or is located at a front location in a 1^{st} second code block in the plurality of second code blocks. For a specific implementation in which the redundant information is located before the second check block, refer to the example shown in FIG. 8. For a specific implementation in which the redundant information is located after the second check block, refer to the example shown in FIG. 9. Details are not described herein again.

Optionally, in the plurality of second code blocks, the second check block is located in one or more consecutive code blocks. For an example in which the second check block is located in a plurality of consecutive second code blocks, refer to the example shown in FIG. 8. For an example in which the second check block is located in a single second code block, refer to the example shown in FIG. 9. Details are not described herein again.

Optionally, the data packet includes a second data group, and the second data group includes the plurality of second code words. For a specific implementation in which the data packet includes the second data group, refer to the examples shown in FIG. 4 to FIG. 9. Details are not described herein again.

Optionally, the sending device receives feedback information corresponding to the second data group. Correspondingly, the receiving device sends the feedback information corresponding to the second data group. For a specific implementation in which the receiving device sends the feedback information for the second data group to the sending device, refer to the examples shown in FIG. 4 to FIG. 9. Details are not described herein again.

Optionally, the plurality of second code words include at least two second code words whose code rates are different. For a specific implementation in which the plurality of second code words include at least two second code words whose code rates are different, refer to the examples shown in FIG. 4 to FIG. 9. Details are not described herein again.

FIG. 12 is a schematic flowchart of another communication method 1200 according to an embodiment of this application. The communication method 1200 shown in FIG. 12 is slightly different from the communication method 400 shown in FIG. 4. The following describes the communication method 1200 with reference to FIG. 12 and FIG. 13.

1201: A sending device generates a data packet, where the data packet includes a plurality of first code words, the plurality of first code words are obtained by performing first encoding on a plurality of first code blocks, and each of the plurality of first code blocks includes a first information block and a first check block used to check the first information block.

FIG. 13 shows a structure of a data packet. The data packet shown in FIG. 13 may be the data packet generated by the sending device in 1201.

In the example shown in FIG. 13, the data packet may include H first code words, and H is an integer greater than 1. Different from the data packet shown in FIG. 5, the data packet shown in FIG. 13 may not include a second code word.

Optionally, the sending device obtains at least one first information block, and the sending device generates at least one first check block in the at least one first code block, where the first check block corresponds to a first information block in a first code block in which the first check block is located. For a specific implementation of generating the at least one first code block, refer to the examples shown in FIG. 4 to FIG. 9. Details are not described herein again.

1202: The sending device sends the data packet.

Correspondingly, a receiving device receives the data packet from the sending device.

1203: The receiving device performs first decoding on the plurality of first code words, to obtain the plurality of first code blocks, where each of the plurality of first code blocks includes the first information block and the first check block used to check the first information block.

For a specific implementation in which the receiving device performs first decoding on the plurality of first code words, refer to the examples shown in FIG. 4 to FIG. 9. Details are not described herein again.

Optionally, the data packet includes L-1 data groups, the L-1 data groups include L₁ first data groups, each of the L₁ first data groups includes n first code words, and L₁ and n are greater than or equal to 1. Optionally, n meets n=ceil(H/(L-1)), and H is a total quantity of the at least one first code word. Optionally, when mod(H, (L-1))>0, the L-1 data groups further include L₂ third data groups, and each of the L₂ third data groups includes p first code words, where L₂ is a positive integer less than L-L₁, and p meets p=floor(H/(L-1)). Optionally, L₁ meets L₁=mod(H, (L-1)), and L₂ meets L₂=L-mod(H, (L-1))-1. For a specific implementation of dividing the H first code words into one or more data groups, refer to the examples shown in FIG. 4 to FIG. 9. Details are not described herein again.

Optionally, the sending device receives L-1 pieces of feedback information that are in a one-to-one correspondence with the L-1 data groups. Correspondingly, the receiving device sends the L-1 pieces of feedback information that are in the one-to-one correspondence with the L-1 data groups. For a specific implementation in which the receiving device sends the feedback information for the L-1 data groups to the sending device, refer to the examples shown in FIG. 4 to FIG. 9. Details are not described herein again.

Optionally, the at least one first code word has a same code length. For descriptions of the code length of the first code word, refer to the examples shown in FIG. 4 to FIG. 9. Details are not described herein again.

It should be understood that the method shown in FIG. 12 may be performed by an electronic device having a communication function. For example, the sending device may be a terminal device, and the receiving device may be a network device. For another example, the sending device may be a network device, and the receiving device may be a terminal device. For another example, the sending device may be a terminal device 1, and the receiving device may be a terminal device 2.

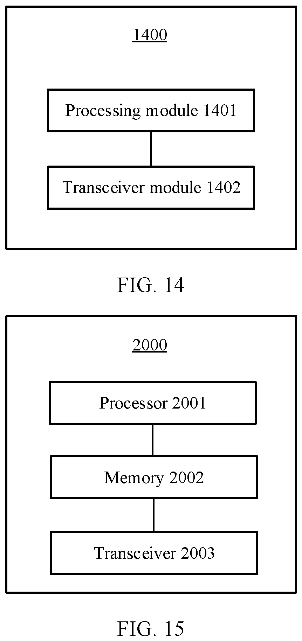

FIG. 14 is a schematic diagram of a structure of a communication apparatus according to an embodiment of this application. The communication apparatus may be a terminal device or a network device, or may be a component (for example, a chip or a circuit) that may be used for a terminal device or a network device. As shown in FIG. 14, the communication apparatus 1400 may include a processing module 1401 and a transceiver module 1402.

In an example, the processing module 1401 is configured to generate a data packet, where the data packet includes at least one first code word and at least one second code word, a code length of the first code word is greater than a code length of the second code word, the at least one first code word is obtained by performing first encoding on at least one first code block, each of the at least one first code block includes a first information block and a first check block used to check the first information block, the at least one second code word is obtained by performing at least one type of second encoding on at least one second code block, the at least one second code block includes a second check block, and the second check block is used to check a portion of information in the at least one second code block. The transceiver module 1402 is configured to send the data packet.

In another example, the transceiver module 1402 is configured to receive a data packet, where the data packet includes at least one first code word and at least one second code word, and a code length of the first code word is greater than a code length of the second code word. The processing module 1401 is configured to: perform first decoding on the at least one first code word, and perform at least one type of second decoding on the at least one second code word, to obtain at least one first code block and at least one second code block, where each of the at least one first code block includes a first information block and a first check block used to check the first information block, the at least one second code block includes a second check block, and the second check block is used to check a portion of information in the at least one second code block.

In another example, the processing module 1401 is configured to generate a data packet, where the data packet includes a plurality of second code words, the plurality of second code words are obtained by performing at least one type of second encoding on a plurality of second code blocks, the plurality of second code blocks include a second check block, and the second check block is used to check at least a portion of information in the plurality of second code blocks. The transceiver module 1402 is configured to send the data packet.

In another example, the transceiver module 1402 is configured to receive a data packet, where the data packet includes a plurality of second code words. The processing module 1401 is configured to perform at least one type of second decoding on the plurality of second code words, to obtain a plurality of second code blocks, where the plurality of second code blocks include a second check block, and the second check block is used to check a portion of information in the plurality of second code blocks.

In another example, the processing module 1401 is configured to generate a data packet, where the data packet includes a plurality of first code words, the plurality of first code words are obtained by performing first encoding on a plurality of first code blocks, and each of the plurality of first code blocks includes a first information block and a first check block used to check the first information block. The transceiver module 1402 is configured to send the data packet.

In another example, the transceiver module 1402 is configured to receive a data packet, where the data packet includes a plurality of first code words. The processing module 1401 is configured to perform first decoding on the plurality of first code words, to obtain a plurality of first code blocks, where each of the plurality of first code blocks includes a first information block and a first check block used to check the first information block.

The processing module 1401 may be implemented by a processor. The transceiver module 1402 may be implemented by a receiver and/or a transmitter. For specific functions and beneficial effect of the processing module 1401 and the transceiver module 1402, refer to the methods shown in FIG. 4 to FIG. 9. Details are not described herein again.

In a possible embodiment, a communication apparatus is further provided. The communication apparatus may be a terminal device or a network device, or may be a component (for example, a chip or a circuit) used for a terminal device or a network device. The communication apparatus may include a transceiver and a processor, and optionally, may further include a memory. The transceiver may be configured to implement corresponding functions and operations of the receiving module and the sending module. The processor may be configured to implement a corresponding function and operation of the processing module. The memory may be configured to store executable instructions or application program code, and the processor controls execution of the executable instructions or the application program code, to implement the communication method provided in embodiments of this application; and/or the memory may be configured to temporarily store some data and instruction information, and the like. The memory may be independent of the processor. In this case, the memory may be connected to the processor through a communication line. In another possible design, the memory may alternatively be integrated with the processor. This is not limited in this embodiment of this application.

FIG. 15 is a structural block diagram of a communication apparatus 2000 according to an embodiment of the present invention. The communication apparatus 2000 may be a terminal device or a network device. As shown in FIG. 15, the communication apparatus 2000 includes a processor 2001, a memory 2002, a radio frequency circuit, an antenna, and an input/output apparatus. The processor 2001 is mainly configured to process a communication protocol and communication data, control the communication apparatus 2000, execute a software program, process data of the software program, and the like. The memory 2002 is mainly configured to store the software program and the data. The radio frequency circuit is mainly configured to: perform conversion between a baseband signal and a radio frequency signal, and process the radio frequency signal. The antenna is mainly configured to send and receive radio frequency signals in a form of an electromagnetic wave. The input/output apparatus, such as a touchscreen, a display, or a keyboard, is mainly configured to: receive data input by a user and output data to the user. It should be noted that some types of communication apparatuses 2000 may have no input/output apparatus.

When data needs to be sent, the processor 2001 performs baseband processing on the to-be-sent data, and outputs a baseband signal to the radio frequency circuit. After performing radio frequency processing on the baseband signal, the radio frequency circuit sends a radio frequency signal in an electromagnetic wave form through the antenna. When data is sent to the communication apparatus 2000, the radio frequency circuit receives a radio frequency signal through the antenna, converts the radio frequency signal into a baseband signal, and outputs the baseband signal to the processor. The processor converts the baseband signal into data, and processes the data. For ease of description, FIG. 15 shows only one memory and one processor. In an actual product of the communication apparatus 2000, there may be one or more processors and one or more memories. The memory may also be referred to as a storage medium, a storage device, or the like. The memory may be disposed independent of the processor, or may be integrated with the processor. This is not limited in embodiments of this application.

In this embodiment of this application, the antenna and the radio frequency circuit that have receiving and sending functions may be considered as a transceiver 2003 of the communication apparatus 2000, and the processor that has a processing function may be considered as a processing unit of the communication apparatus 2000. The transceiver may also be referred to as a transceiver unit, a transceiver, a transceiver apparatus, or the like. The processing unit may also be referred to as a processor, a processing board, a processing module, a processing apparatus, or the like. Optionally, a component that is in the transceiver 2003 and that is configured to implement a receiving function may be considered as a receiving unit, and a component that is in the transceiver 2003 and that is configured to implement a sending function may be considered as a sending unit. In other words, the transceiver 2003 includes the receiving unit and the sending unit. The receiving unit sometimes may also be referred to as a receiver machine, a receiver, a receive circuit, or the like. The sending unit sometimes may also be referred to as a transmitter machine, a transmitter, a transmit circuit, or the like.

The processor 2001, the memory 2002, and the transceiver 2003 communicate with each other through an internal connection channel, to transmit a control signal and/or a data signal.

The method disclosed in embodiments of the present invention may be applied to the processor 2001, or may be implemented by the processor 2001. The processor 2001 may be an integrated circuit chip, and has a signal processing capability. In an implementation process, the steps of the method may be completed by using an integrated logic circuit of hardware in the processor 2001 or instructions in a form of software.

The processor in embodiments of this application may be a general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, or a discrete hardware component. The processor may implement or perform the methods, the steps, and logical block diagrams that are disclosed in embodiments of the present invention. The general-purpose processor may be a microprocessor, or the processor may be any conventional processor or the like. Steps of the methods disclosed with reference to embodiments of the present invention may be directly executed and accomplished using a hardware decoding processor, or may be executed and accomplished by using a combination of hardware and software modules in the decoding processor. The software module may be located in a mature storage medium in the art, such as a random access memory (random access memory, RAM), a flash memory, a read-only memory (read-only memory, ROM), a programmable read-only memory, an electrically erasable programmable memory, or a register. The storage medium is located in the memory, and the processor reads instructions in the memory and completes the steps in the method in combination with hardware of the processor.

Optionally, in some embodiments, the memory 2002 may store instructions used to perform the method performed by the sending device or the receiving device in the methods shown in FIG. 4 to FIG. 13. The processor 2001 may execute the instructions stored in the memory 2002 and complete, in combination with other hardware (for example, the transceiver 2003), the steps performed by the sending device or the receiving device in the methods shown in FIG. 4 to FIG. 13. For a specific working process and beneficial effect, refer to the descriptions in embodiments shown in FIG. 4 to FIG. 13.

An embodiment of this application further provides a chip. The chip includes a transceiver unit and a processing unit. The transceiver unit may be an input/output circuit or a communication interface. The processing unit is a processor, a microprocessor, or an integrated circuit integrated on the chip. The chip may perform the method on the sending device side or the receiving device side in the method embodiments.

An embodiment of this application further provides a terminal device, configured to perform the method on the sending device side or the receiving device side in the method embodiments. In an example, the terminal device may include the communication apparatus shown in FIG. 14 or FIG. 15. The terminal device may be a communication node or a device in which a communication node is located. The terminal device may alternatively be an intelligent transportation device, for example, a vehicle, an uncrewed aerial vehicle, or a vehicle-mounted chip. The terminal device may alternatively be a smart manufacturing device, for example, an industrial manufacturing system or a battery management system. The terminal device may alternatively be a smart home device, for example, a television, a stereo, a camera, a voice assistant, a smart curtain, or a smart lamp. The terminal device may alternatively be an intelligent terminal device, for example, a mobile phone, a tablet computer, a headset, a watch, a microphone, or a vehicle-mounted device.

An embodiment of this application further provides a computer-readable storage medium. The computer-readable storage medium stores instructions, and when the instructions are executed, the method on the sending device side or the receiving device side in the method embodiments is performed.

An embodiment of this application further provides a computer program product including instructions. When the instructions are executed, the method on the sending device side or the receiving device side in the method embodiments is performed.

Terminologies such as "component", "module", and "system" used in this specification are used to indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within a process and/or a thread of execution, and a component may be located on one computer and/or distributed between two or more computers. In addition, these components may be executed from various computer-readable media that store various data structures. For example, the components may communicate by using a local and/or remote process and based on, for example, a signal having one or more data packets (for example, data from two components interacting with another component in a local system, a distributed system, and/or across a network such as the Internet interacting with another system by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for convenient and brief description, for a detailed working process of the foregoing system, apparatus, and unit, refer to a corresponding process in the method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected based on an actual requirement to achieve an objective of the solutions of embodiments.

In addition, functional units in embodiments of this application may be integrated into one processing unit, or each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A communication method, wherein the method comprises:
generating a data packet, wherein the data packet comprises at least one first code word and at least one second code word, and a code length of the first code word is greater than a code length of the second code word; and
sending the data packet, wherein
the at least one first code word is obtained by performing first encoding on at least one first code block, each of the at least one first code block comprises a first information block and a first check block used to check the first information block, the at least one second code word is obtained by performing at least one type of second encoding on at least one second code block, the at least one second code block comprises a second check block, and the second check block is used to check a portion of information in the at least one second code block.

2. The communication method according to claim 1, wherein the method further comprises:
obtaining at least one first information block; and
generating at least one first check block in the at least one first code block, wherein the first check block corresponds to a first information block in a first code block in which the first check block is located.

3. The communication method according to claim 1 or 2, wherein the second check block is generated based on at least a portion of information other than the second check block in the at least one second code block.

4. The communication method according to any one of claims 1 to 3, wherein the at least one second code block comprises redundant information, and in the at least one second code block, the redundant information is located before or after the second check block, or is located at a front location in a 1^{st} second code block in the at least one second code block.

5. The communication method according to any one of claims 1 to 4, wherein in the at least one second code block, the second check block is located in one or more consecutive code blocks.

6. The communication method according to any one of claims 1 to 5, wherein the data packet comprises L data groups, the L data groups comprise L₁ first data groups and one second data group, each of the L₁ first data groups comprises n first code words, the second data group comprises the at least one second code word, and L₁ and n are greater than or equal to 1.

7. The communication method according to claim 6, wherein the method further comprises:
receiving L pieces of feedback information corresponding to the data packet, wherein the L pieces of feedback information correspond to the L data groups.

8. The communication method according to claim 6 or 7, wherein n meets n=ceil(H/(L-1)), and H is a total quantity of the at least one first code word.

9. The communication method according to claim 8, wherein when mod(H, (L-1))>0, the L data groups further comprise L₂ third data groups, and each of the L₂ third data groups comprises p first code words, wherein L₂ is a positive integer less than L-L₁, and p meets p=floor(H/(L-1)).

10. The communication method according to claim 9, wherein L₁ meets L₁=mod(H, (L-1)), and L₂ meets L₂=L-mod(H, (L-1))-1.

11. The communication method according to any one of claims 1 to 10, wherein the at least one first code word has a same code length.

12. The communication method according to any one of claims 1 to 11, wherein the at least one second code word comprises at least two second code words whose code rates are different.

13. The communication method according to any one of claims 1 to 12, wherein a code length sum of the at least one second code word is less than the code length of the first code word.

14. A communication method, wherein the method comprises:
receiving a data packet, wherein the data packet comprises at least one first code word and at least one second code word, and a code length of the first code word is greater than a code length of the second code word;
performing first decoding on the at least one first code word to obtain at least one first code block; and
performing at least one type of second decoding on the at least one second code word to obtain at least one second code block, wherein each of the at least one first code block comprises a first information block and a first check block used to check the first information block, the at least one second code block comprises a second check block, and the second check block is used to check a portion of information in the at least one second code block.

15. The communication method according to claim 14, wherein the first information block in the first code block is obtained through check decoding based on the first check block in the first code block.

16. The communication method according to claim 14 or 15, wherein at least a portion of information other than the second check block in the at least one second code block is obtained through check decoding based on the second check block.

17. The communication method according to any one of claims 14 to 16, wherein the at least one second code block comprises redundant information, and in the at least one second code block, the redundant information is located before or after the second check block, or is located at a front location in a 1^{st} second code block in the at least one second code block.

18. The communication method according to any one of claims 14 to 17, wherein in the at least one second code block, the second check block is located in one or more consecutive code blocks.

19. The communication method according to any one of claims 14 to 18, wherein the data packet comprises L data groups, the L data groups comprise L₁ first data groups and one second data group, each of the L₁ first data groups comprises n first code words, the second data group comprises the at least one second code word, and L₁ and n are greater than or equal to 1.

20. The communication method according to claim 19, wherein the method further comprises:
sending L pieces of feedback information corresponding to the data packet, wherein the L pieces of feedback information correspond to the L data groups.

21. The communication method according to claim 19 or 20, wherein n meets n=ceil(H/(L-1)), and H is a total quantity of the at least one first code word.

22. The communication method according to claim 21, wherein when mod(H, (L-1))>0, the L data groups further comprise L₂ third data groups, and each of the L₂ third data groups comprises p first code words, wherein L₂ is a positive integer less than L-L₁, and p meets p=floor(H/(L-1)).

23. The communication method according to claim 22, wherein L₁ meets L₁=mod(H, (L-1)), and L₂ meets L₂=L-mod(H, (L-1))-1.

24. The communication method according to any one of claims 14 to 23, wherein the at least one first code word has a same code length.

25. The communication method according to any one of claims 14 to 24, wherein the at least one second code word comprises at least two second code words whose code rates are different.

26. The communication method according to any one of claims 14 to 25, wherein a code length sum of the at least one second code word is less than the code length of the first code word.

27. A communication method, wherein the method comprises:
generating a data packet, wherein the data packet comprises a plurality of second code words; and
sending the data packet, wherein
the plurality of second code words are obtained by performing at least one type of second encoding on a plurality of second code blocks, the plurality of second code blocks comprise a second check block, and the second check block is used to check at least a portion of information in the plurality of second code blocks.

28. The communication method according to claim 27, wherein the second check block is generated based on at least a portion of information other than the second check block in the at least one second code block.

29. The communication method according to claim 27 or 28, wherein the plurality of second code blocks comprise redundant information, and in the plurality of second code blocks, the redundant information is located before or after the second check block.

30. A communication method, wherein the method comprises:
receiving a data packet, wherein the data packet comprises a plurality of second code words; and
performing at least one type of second decoding on the plurality of second code words, to obtain a plurality of second code blocks, wherein the plurality of second code blocks comprise a second check block, and the second check block is used to check a portion of information in the plurality of second code blocks.

31. The communication method according to claim 30, wherein at least a portion of information other than the second check block in the at least one second code block is obtained through check decoding based on the second check block.

32. A communication apparatus, comprising:
a processing module, configured to generate a data packet, wherein the data packet comprises at least one first code word and at least one second code word, and a code length of the first code word is greater than a code length of the second code word; and
a sending module, configured to send the data packet, wherein
the at least one first code word is obtained by performing first encoding on at least one first code block, each of the at least one first code block comprises a first information block and a first check block used to check the first information block, the at least one second code word is obtained by performing at least one type of second encoding on at least one second code block, the at least one second code block comprises a second check block, and the second check block is used to check a portion of information in the at least one second code block.

33. A communication apparatus, comprising:
a receiving module, configured to receive a data packet, wherein the data packet comprises at least one first code word and at least one second code word, and a code length of the first code word is greater than a code length of the second code word; and
a processing module, configured to: perform first decoding on the at least one first code word to obtain at least one first code block, and perform at least one type of second decoding on the at least one second code word to obtain at least one second code block, wherein each of the at least one first code block comprises a first information block and a first check block used to check the first information block, the at least one second code block comprises a second check block, and the second check block is used to check a portion of information in the at least one second code block.

34. A communication apparatus, wherein the apparatus comprises:
a processing module, configured to generate a data packet, wherein the data packet comprises a plurality of second code words; and
a sending module, configured to send the data packet, wherein
the plurality of second code words are obtained by performing at least one type of second encoding on a plurality of second code blocks, the plurality of second code blocks comprise a second check block, and the second check block is used to check a portion of information in the plurality of second code blocks.

35. A communication apparatus, wherein the apparatus comprises:
a receiving module, configured to receive a data packet, wherein the data packet comprises a plurality of second code words; and
a processing module, configured to perform at least one type of second decoding on the plurality of second code words, to obtain a plurality of second code blocks, wherein the plurality of second code blocks comprise a second check block, and the second check block is used to check a portion of information in the plurality of second code blocks.

36. A communication apparatus, wherein the communication apparatus comprises at least one processor and a communication interface, the communication interface is used by the communication apparatus to exchange information with another communication apparatus, and when program instructions are executed in the at least one processor, the communication apparatus is enabled to implement the communication method according to any one of claims 1 to 31.

37. A terminal device, comprising the communication apparatus according to any one of claims 32 to 35.

38. A computer program storage medium, wherein the computer-readable storage medium stores computer program code, and when the computer program code is run on a computer, the computer is enabled to perform the communication method according to any one of claims 1 to 31.

39. A chip system, wherein the chip system comprises at least one processor, and when program instructions are executed in the at least one processor, the communication method according to any one of claims 1 to 31 is implemented.
